Europäisches Patentamt

European Patent Office

Office européen des brevets

(19)

(11) Veröffentlichungsnummer : **0 378 538 B1**

(12) **EUROPÄISCHE PATENTSCHRIFT**

(45) Veröffentlichungstag der Patentschrift :
29.01.92 Patentblatt 92/05

(51) Int. Cl.$^5$ : **G06F 11/26**, G06F 11/20,
G11C 29/00

(21) Anmeldenummer : 88905700.6

(22) Anmeldetag : 11.07.88

(86) Internationale Anmeldenummer :
PCT/DE88/00432

(87) Internationale Veröffentlichungsnummer :
WO 89/02122 09.03.89 Gazette 89/06

(54) ANORDNUNG UND VERFAHREN ZUR FESTSTELLUNG UND LOKALISIERUNG VON FEHLERHAFTEN SCHALTKREISEN EINES SPEICHERBAUSTEINS.

(30) Priorität : 26.08.87 DE 3728521

(43) Veröffentlichungstag der Anmeldung :
25.07.90 Patentblatt 90/30

(45) Bekanntmachung des Hinweises auf die
Patenterteilung :
29.01.92 Patentblatt 92/05

(84) Benannte Vertragsstaaten :
AT DE FR GB IT NL

(56) Entgegenhaltungen :
EP-A- 0 186 459
EP-A- 0 242 854

(56) Entgegenhaltungen :
US-A- 3 995 261
US-A- 4 191 996
US-A- 4 460 999
Patent Abstracts of Japan, vol. 7, Nr. 58 (E-163)
(1203) 10 March 1983

(73) Patentinhaber : SIEMENS
AKTIENGESELLSCHAFT
Wittelsbacherplatz 2
W-8000 München 2 (DE)

(72) Erfinder : MÜLLER, Bruno
Hundhammerweg 18
W-8000 München 83 (DE)
Erfinder : RITTER, Hartmut
Sudetenweg 22
W-8151 Feldkirchen (DE)

EP 0 378 538 B1

## Beschreibung

Die Erfindung bezieht sich auf eine Anordnung und ein Verfahren zur Feststellung und Lokalisierung von fehlerhaften Schaltkreisen eines Speicherbausteins insbesondere fehlerhaften Speicherzellen nach der Methode des Selbsttestes.

Speicher nehmen sowohl als Einzelelemente eines Rechnersystems als auch als Speichermodule auf hoch integrierten Bausteinen eine wichtige Rolle ein. Ihre Entwicklung wird weltweit mit großem Einsatz vorangetrieben. Zur Zeit verfügbare Speicher haben Kapazitäten bis zu einem Megabit. Der Trend geht zu Speicherbausteinen noch höherer Kapazität.

Zur Zeit werden Speicher mit Hilfe von Testautomaten geprüft. Diese können meistens nur einen Baustein zugleich testen. Während die Fertigungskosten im wesentlichen von der Chipfläche abhängen, steigt der Testaufwand mit der Zahl der zu testenden Elemente pro Baustein an. Deshalb nimmt der Anteil der Testkosten bei den Bausteinkosten zu. Eine Verbesserung dieser Situation ist durch die Einführung von Selbsttestverfahren zu erwarten. Hierbei werden einige Funktionen des Testautomaten durch zusätzliche Schaltungen in den zu prüfenden Baustein verlagert. Durch das sog. On Chip Prüfen werden nicht nur statische, sondern auch einige dynamische Fehler erkennbar. Der Selbsttest kann für alle Bausteine eines Wafers bzw. für mehrere Bausteine parallel ablaufen. Dies verkürzt die Testzeit. Zudem ist es möglich, für einen späteren Baugruppen- bzw. Systemtest den Selbsttest der Bausteine ebenfalls heranzuziehen.

Es ist weiterhin bekannt, fehlerhafte Speicherzellen eines Speichers mit Hilfe von Zusatzzeilen an Speicherzellen oder Zusatzspalten an Speicherzellen zu reparieren. Um eine solche Reparatur durchführen zu können, müssen die Adressen der fehlerhaften Speicherzellen festgestellt und festgehalten werden. Dies erfolgt mit Hilfe des Testautomaten, der dem Speicherbaustein Testmuster zuführt und die daraufhin vom Speicherbaustein abgegebenen Ergebnissignale überprüft. Die Auswertung der Ergebnissignale ergibt, ob fehlerhafte Speicherzellen vorhanden sind. Die Adressen von fehlerhaften Speicherzellen werden dann im Testautomaten gespeichert. Nach Beendigung des Testes wird ein Reparaturplan erstellt, der angibt, wie die Zeilen bzw. Spalten mit fehlerhaften Speicherzellen durch Ersatzzeilen bzw. Ersatzspalten ersetzt werden müssen. Die ausgewählten Ersatzzeilen oder Ersatzspalten werden durch Umprogrammieren aktiviert und die Zeilen bzw. Spalten mit fehlerhaften Speicherzellen werden abgeschaltet. Zum Umprogrammieren werden z.B. mit Hilfe von Laserlicht aktivierbare Sicherungen verwendet. Derartige Verfahren sind z.B. bekannt aus JST News Vol. 3, Nr. 2, April 1984, S. 18 - 26, IEEE Journal of Solid State Circuits, Vol. SC-18, Nr. 5, Okt. 1983, S. 562 bis 567, IEEE Journal of Solid State Circuits, Vol. SC 16, Nr. 5, Okt. 1981, S. 506 bis 513, IEEE Design und Test, Vol. 6, S. 35 - 44, 1985, Electronics, 12.Jan.1984, S.175 bis 179. Ein solches Verfahren ist auch aus der US-A-4 460 999 bekannt.

Aus US-A-4 191 996 ist ein Rechner- und Speichersystem auf einem Wafer bekannt, der redundante Bausteine aufweist. Das System stellt selbständig fest, welche CPU-, ROM- und RAM-Bausteine fehlerfrei sind und schaltet sich dementsprechend zu einem Rechner- und Speichersystem zusammen.

Bisher bekannte Speicherselbsttestverfahren unterstützen die oben angegebenen Reparaturmöglichkeiten nicht. Die Selbsttestverfahren liefern nur eine Aussage darüber, ob der Speicherbaustein fehlerhaft ist oder nicht fehlerhaft ist. Der Selbsttest von reparierbaren Speicherbausteinen erfordert aber neben einer Fehlererkennung zusätzlich, daß die fehlerhaften Speicherzellen lokalisiert werden und daß eine entsprechende Fehlerliste erstellt wird.

Die der Erfindung zugrundeliegende Aufgabe besteht darin, eine Anordnung und ein Verfahren zur Feststellung und Lokalisierung von fehlerhaften Speicherzellen eines Speicherbausteins anzugeben, die nach der Methode des Selbsttestes des Speicherbausteins arbeitet. Mit Hilfe dieser Anordnung und deren Verfahren kann ein Selbsttest jedes Speicherbausteins durchgeführt werden und zudem aufgrund festgestellter fehlerhafter Speicherzellen ein Reparaturplan erstellt werden. Damit werden die Vorteile der Selbsttestverfahren bei Speicherbausteinen und die Vorteile der Reparaturmöglichkeit von Speicherbausteinen großer Kapazität erreicht.

Diese Aufgabe wird bei einer Anordnung der eingangs angegebenen Art entsprechend den Merkmalen des Patentanspruchs 1 gelöst.

Die Aufgabe wird weiterhin mit einem Verfahren entsprechend dem Patentanspruch 9 gelöst.

Der Testprozessor erzeugt die Testmuster für den zu prüfenden Speicherbaustein, wertet die aufgrund der Testmuster vom Speicher abgegebenen Ergebnismuster aus und stellt fest, ob fehlerhafte Speicherzellen im Speicher enthalten sind. Ist dies der Fall, dann wird die Adresse dieser fehlerhaften Speicherzellen abgespeichert. Dies kann im Registersatz des Testprozessors oder in einem fehlerfreien Bereich des Speichers auf dem Halbleiterbaustein erfolgen. Zudem kann der Testprozessor einen Reparaturplan zur Reparatur des Speichers erstellen. Der Testprozessor kann diesen Reparaturplan an ein externes Programmiergerät abgeben, das dann auf bekannte Weise den Speicher repariert. Vorteilhaft ist es jedoch, wenn der Testprozessor selbst die Reparatur ausführt. Dies ist dann möglich, wenn der Speicher programmierbare Zellen enthält, die durch Signale vom Testprozessor beeinflußbar sind. Dies könnten z.B. EPROM-Zellen sein, die auf bekannte Weise in die Ansteuerschaltkreise für die Ersatzzeilen bzw. Ersatzspalten von Speicherzellen eingefügt sind und die vom Testprozessor entsprechend dem Reparaturplan so eingestellt werden, daß die Ansteuerschaltkreise, z.B. die Decoderschaltkreise, der Ersatzzeilen bzw. Ersatzspalten anstatt der Zeilen bzw. Spalten mit fehlerhaften Speicherzellen eingeschaltet sind.

Der Testprozessor übernimmt somit die Aufgaben eines Testautomaten für den Test reparierbarer Speicher und geht dabei nach der Selbsttestmethode vor. Dabei ist der Testprozessor so ausgeführt, daß die Anzahl der zu speichernden Adressen von fehlerhaften Speicherzellen auf einen minimalen Satz beschränkt ist. Diese Zahl kann vom verfügbaren Reparaturpotential abgeleitet werden. Außerdem dient sie als ein Kriterium, um schon während einer schrittweisen Testmusterauswertung entscheiden zu können, ob der Speicher noch repariert werden kann. Dies hat den Vorteil, daß der Testlauf bereits frühzeitig abgebrochen werden kann, wenn ein Weitertesten sinnlos wäre.

Gegenüber einer fest verdrahteten Ablaufsteuerung bietet der Testprozessor eine höhere Flexibilität, sowohl beim Einsatz, als auch bei der Anpassung an zukünftige Speicherorganisationen. Diese Anpassung kann mit Hilfe einer Änderung der Testprogramme auf einfache Weise erfolgen. Entsprechendes gilt bei geändertem Reparaturpotential. Die Prüfwortbreite läßt sich zudem durch die Bitslicetechnik im Datenpfad parametrisieren.

Der Testprozessor kann also sowohl den Test bei der Eingangskontrolle, als auch die Wartungs- und Einschaltkontrollen im System unterstützen. Es ist auch denkbar, daß der Testprozessor den normalen Prozessor im Betriebszustand des Speichers unterstützt, z.B. bisher extern gesteuerte Aufgabe, wie die Refreshsteuerung bei dynamischen Speichern, ausführt.

Um eine einfache Prozessorarchitektur zu ermöglichen, kann der Befehlsatz auf wenige elementare Funktionen beschränkt werden. Dies führt zu einem geringen Flächenbedarf auf dem Halbleiterbaustein und zu hoher Verarbeitungsleistung. Zum Beispiel wird ein solcher Testprozessor auf einem dynamischen Megabitspeicher einen Flächenbedarf von ungefähr 5% haben.

Weitere Ausbildungen der Erfindung ergeben sich aus den Unteransprüchen.

Anhand eines Ausführungsbeispiels, das in den Figuren dargestellt ist, wird die Erfindung weiter erläutert. Es zeigen

Fig. 1 ein Prinzipschaltbild des Speicherbausteins mit Testprozessor,

Fig. 2 die Architektur des Testprozessors,

Fig. 3 den Befehlsatz,

Fig. 4 ein Blockschaltbild der Steuerung und des Datenpfades,

Fig. 5 ein Blockschaltbild des Befehlsdecoders,,

Fig. 6 ein Flußdiagramm, das das Selbsttestverfahren zeigt,

Fig. 7 ein Flußdiagramm, das das Verfahren zum Abspeichern der Adressen von fehlerhaften Speicherzellen zeigt.

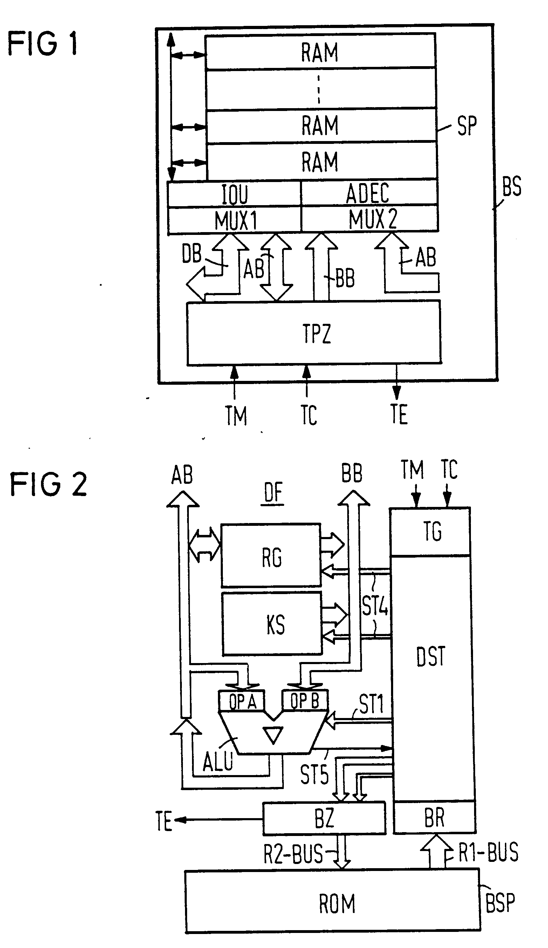

Aus Fig. 1 ergibt sich ein Prinzipschaltbild eines Speicherbausteins BS, auf dem ein RAM Speicher SP aus verschiedenen Modulen integriert ist. Zur Ansteuerung des Speichers SP ist auf übliche Weise ein Adreßdecoder ADEC und eine Eingabe/Ausgabeeinheit IOU vorgesehen. Zusätzlich zu diesem bekannten Aufbau des Speichers SP wird nun ein Testprozessor TPZ auf dem Speicherbaustein BS mit integriert. Dieser Testprozessor TPZ kann über Multiplexer MUX1 und MUX2 mit dem Speicher SP verbunden werden. Dazu führen ein Datenbus A und ein Adreßbus B zum Speicher SP. Die Multiplexer MUX1 und MUX2 sind erforderlich, um den Adreßdecoder ADC bzw. Ein/Ausgabeeinheit IOU über einen Datenbus DB und einen Adreßbus AB mit anderen Einheiten verbinden zu können.

Der Speicher SP kann auf übliche Weise aufgebaut sein, er kann z.B. wortorganisiert sein, jedoch muß erforderlich sein, daß jede Speicherzelle des Speichers auswählbar ist. Auf übliche Weise kann ein solcher Speicher SP also aus Wortleitungen und Bitleitungen oder Zeilen von Speicherzellen und Spalten von Speicherzellen bestehen.

Der Testprozessor TPZ wird von außen mit einem Signal Testmode TM eingeschaltet, ihm wird weiterhin ein Tatksignal TC von außen zugeführt. Wenn der Testprozessor TPZ seine Tätigkeit beendet hat, meldet er dies mit einem Testendesignal TE.

Wenn ein vom Testprozessor TPZ erstellter Reparaturplan an ein externes Gerät, z.B. ein Gerät, das die Reparatur durchführen soll, abgegeben werden soll, gibt der Testprozessor TPZ eine entsprechende Adresse an dieses Gerät ab, unter der der Reparaturplan im Speicherbaustein SP abgespeichert ist.

Die Architektur des Prozessors ergibt sich aus Fig. 2. Der Testprozessor TPZ kann in drei Einheiten unterteilt werden, nämlich einen Datenpfad DF, eine Datenpfadsteuerung DST und einen ROM Speicher BSP. Der Datenpfad DF besteht aus einem Registersatz RG, einem Konstanten Speicher KS und einer arithmetisch logischen Einheit ALU. Die arithmetisch logische Einheit ALU weist zudem ein Operandenregister OPA und ein Operandenregsiter OPB auf. Der Registersatz RG und die ALU ist sowohl mit dem Datenbus AB als auch mit dem Adreßbus BB verbunden. Der Konstantenspeicher KS dagegen ist nur mit dem Adreßbus BB verbunden.

Im Registersatz RG werden z.B. die Adressen für den Speicher SP gebildet, weiterhin werden die vom Speicher ausgelesenen Informationen in den Registersatz RG abgespeichert. Aus dem Konstanten Speicher KS können die Testmuster für den Speicher SP entnommen werden.

Die Datenpfadsteuerung DST erzeugt aus Befehlsworten Steuersignale für den Registersatz RG, den Konstanten Speicher KS und die arithmetisch logische Einheit ALU. Dazu werden der Datenpfadsteuerung DST Befehlsworte eines Testprogramms aus dem Speicher BSP zugeführt. Der Speicher BSP enthält nämlich die Testprogramme, die vom Testprozessor TPZ ausgeführt werden können. Jedes Befehlswort wird zunächst einem Befehlsregister BR zugeleitet, dann von dort zur Datenpfadsteuerung DST, wo es decodiert wird und die dem Operationscode des Befehlswortes zugeordneten Steuersignale ST erzeugt werden. Teil der Datenpfadsteuerung DST ist ein Taktgenerator TG, der die zum Betrieb der Datenpfadsteuerung DST erforderlichen Taktsignale erzeugt. Diesem Taktgenerator TG wird das Taktsignal TC von außen zugeführt.

Zum Ablauf ist weiterhin ei-n Befehlszähler BZ erforderlich, in dem die Adresse gebildet wird, unter der das nächste zu bearbeitende Befehlswort im Speicher BSP gespeichert ist.

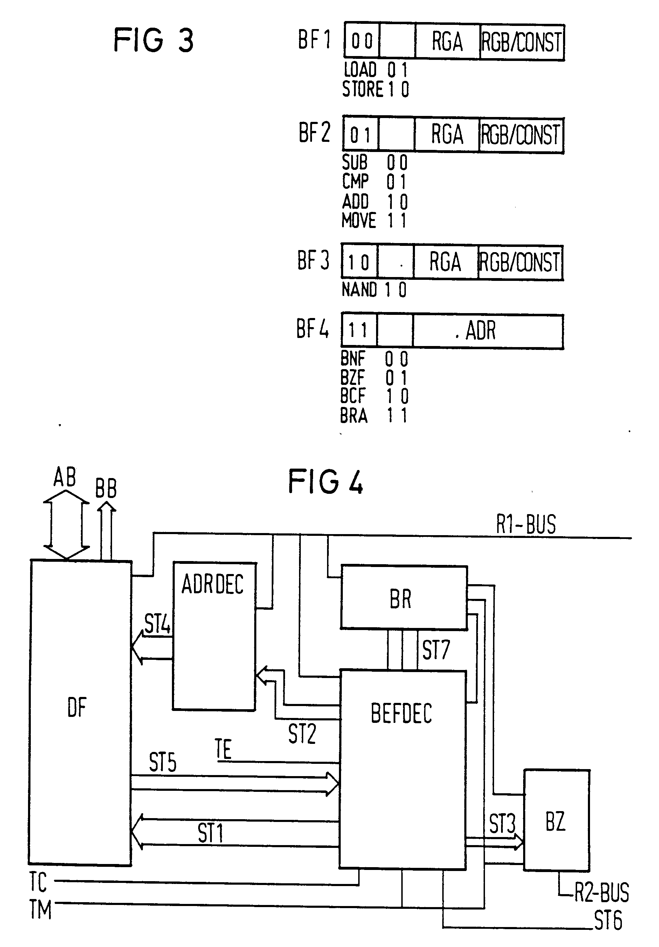

Der Befehlssatz des Testprozessors TPZ kann in vier Befehlstypen eingeteilt werden und kann z.B. 11 Befehle im gesamten aufweisen. Die vier verschiedenen Typen sind der Fig. 3 zu entnehmen. Ein erster Befehlstyp BF1 betrifft Speicheroperationen. Mit Hilfe dieser Befehle kann eine Information in eine Speicherzelle des Speichers SP eingeschrieben werden bzw. eine Information aus einer Speicherzelle ausgelesen werden. Dabei wird die Speicherzelle indirekt adressiert, und zwar über eine Adresse, die in einem Register RGB des Registersatzes steht. Zum Beispiel wird zum Lesen des Inhaltes einer Speicherzelle die Zellenadresse aus dem Register des Registersatzes RG auf den BB Bus geladen und an die Adressiereinheit ADEC des Speichers SP angelegt. Der Inhalt der adressierten Speicherzelle wird über die Ein/Ausgabeeinheit IOU auf den A Bus geladen und von dort in einem Register RGA des Registersatzes RG geschrieben. Dieser Lesevorgang erfolgt über den Befehl Load. Das Beschreiben einer Speicherzelle erfolgt analog mit dem Storebefehl.

Der zweite Befehlstyp BF2 veranlaßt arithmetische Operationen in der ALU. Es sind die angegebenen Operationen Subtraktion, Vergleichen, Addieren und Move möglich. Mit dem Befehl Move wird ein Register Register Transfer ausgeführt. Der Inhalt der Operandenregister OPA und OPB wird mit dem Befehl vergleichen oder CMP verglichen. Der Befehl Addieren ADD bzw. Substrahieren SUB wird meistens dazu verwendet, um die Adressen der Speicherzellen im Registersatz RG zu erhöhen oder zu verkleinern.

Ein dritter Befehlstyp BF3 trifft boolsche Operationen mit Hilfe der ALU. Vorgesehen ist ein NAND-Befehl, der hauptsächlich dazu verwendet wird, um Zeilen- oder Spaltenadressen zu maskieren.

Schließlich gibt es noch eine vierte Befehlsart BF4, den Verzweigungsbefehl BNF, BZF, BCF, BRA. Die Verzweigungsadresse ADR wird dabei aus dem Befehlswort entnommen. Es können vier Verzweigungsbedingungen benutzt werden:

a) Es soll verzweigt werden, wenn kein Fehler festgestellt worden ist, dann wird ein FLAG ZF besetzt (Befehl BNF);

b) es soll verzweigt werden, wenn ein Fehler festgestellt worden ist, dann wird ein FLAG NZ gesetzt (Befehl BNZ);

c) es soll verzweigt werden, wenn ein Übertrag oder Carry aufgetreten ist, dann wird ein FLAG CF gesetzt (Befehl BCF);

d) es soll immer verzweigt werden, dann wird ein FLAG RA gesetzt (Befehl BRA).

Die aus diesen Befehlstypen aufgebauten Programme stehen als Testprogramme im Befehlsspeicher BSP. Bei der Ausführung eines Programms wird jeweils ein Befehl in das Befehlsregister BR geladen und anschließend von der Datenpfadsteuerng DST die dem Operationscode des Befehlswortes zugeordneten Steuersignale ST erzeugt und dem Datenpfad DF zugeführt. Der Datenpfad DF veranlaßt dann entsprechend diesen Steuersignalen ST die Operationen entsprechend dem Operationscode des Befehlswortes.

Zum Beispiel wird beim Lesen einer Speicherzelle zunächst in einer ersten Phase der Befehlsausführung die Adresse dieser Speicherzelle auf den BB Bus geladen und dann in einer Phase 2 in den Adressendecoder ADEC eingespeichert. Der Inhalt der adressierten Speicherzelle wird über die Einheit IOU auf den A Bus übertragen und in den Registersatz RG eingespeichert. Dies erfolgt in der Phase 3 und 4. Während der Phase 2 wird der Befehlszähler BZ weitergezählt und während der Phase 3 wird das nächste Befehlswort in das Befehlsregister BZ eingeschrieben. Dieser Ablauf gilt sowohl für den Befehl Load als auch für den Befehl Store.

Für Vergleichsbefehle CMP wird in der Phase 1 der Befehlsausführung die Inhalte der zu vergleichenden Register auf den AB und BB Bus geladen, und von dort der ALU zugeführt, In der Phase 2 werden die beiden Registerinhalte voneinander subtrahiert. Wenn die Inhalte der Register gleich sind, dann wird das FLAG ZF gesetzt.

4

Bei einem Verzweigungsbefehl wird die Verzweigungsbedingung in der Phase 3 überprüft und bei entsprechendem Ergebnis die absolute Adresse aus dem Befehlswort entnommen und in den Befehlszähler BZ geladen. Wenn die Verzweigungsbedingung nicht vorliegt, wird der Befehlszähler BZ auf übliche Weise weiter gezählt. Dies geschieht in der Phase 4.

Aus Fig. 4 ergibt sich der Aufbau der Datenpfadsteuerung DST. Weiterhin ist der Datenpfad DF als Blockschaltbild dargestellt. Die Datenpfadsteuerung besteht aus dem Befehlsregister BR, dem Befehlszähler BZ, dem Adreßdecoder ADRDEC und dem Befehlsdecoder BEFDEC.

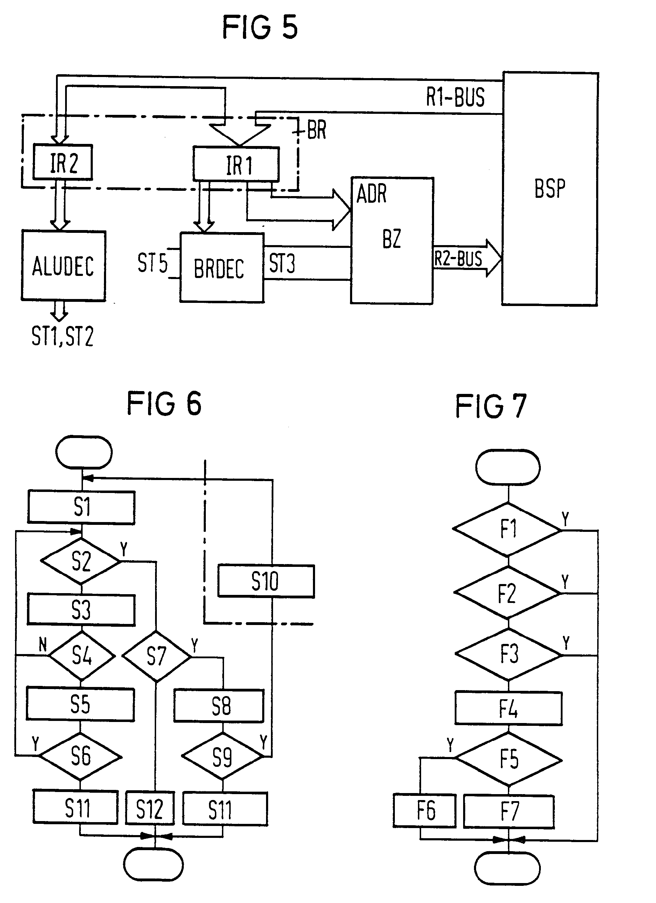

Das Befehlsregister BR dient gleichzeitig als Ausgangsregister des Befehlsspeichers BSP und ist darum über den Bus R1-BUS mit dem Befehlsspeicher BSP verbunden. Das Befehlsregister BR hat zwei Aufgaben zu erfüllen. Es dient zu Beginn des Testvorganges als Signaturregister. Beim späteren Testen erlaubt es ein Pipelining von zwei Befehlen, und ist aus diesem Grund in zwei Teile R1, R2 (Fig.5) unterteilt. Ein Pipelining von zwei Befehlen wird nur dann durchgeführt, wenn der zweite Befehl ein Verzweigungsbefehl ist. Dann kann während der Ausführung des ersten Befehls bereits der zweite, der Verzweigungsbefehl, vorbereitet werden. Die Folge ist, daß die Testzeit sich z.B. um 1/3 verkürzen läßt, da ungefähr 2/7 der Befehle Verzweigungsbefehle sind.

Der Befehlszähler BZ dient als Eingangsregister des Befehlsspeichers BSP. Er ist darum über den Bus R2-BUS mit dem Befehlsspeicher BSP verbunden. Er kann ein einfacher 9 bit-Zähler sein, der auch parallel ladbar ist.

Der Adreßdecoder ADRDEC decodiert die im Befehlswort enthaltenen Register oder Konstanten-Adressen und adressiert über Signale ST4 die Register des Registersatzes RG oder die Speicherzellen des Konstanten-Speichers KS.

Der Aufbau des Befehlsdecoders ergibt sich genau aus Fig. 5. Er besteht aus einem ALU-Decoder ALUDEC, einem Verzweigungsdecoder BRDEC und dem Taktgenerator TG (nicht dargestellt).

Der Verzweigungsdecoder BR DEC prüft den Operationscode des Befehlswortes. Handelt es sich um einen Verzweigungsbefehl und stimmen die FLAG-Bedingungen Signale ST5 von der ALU), so wird der Befehlszähler BZ mit der neuen Adresse geladen (Signale ST3). Andernfalls wird der Befehlszähler BZ lediglich weiter gezählt (Signale ST6).

Der ALU-Decoder ALUDEC erzeugt alle Steuersignale, die fürAusführung aller Befehle (außer Verzweigungsbefehle) notwendig sind. Ein Teil Steuersignale führt zur ALU (Signal ST1), ein Teil zum Adressendecoder ADRDEC (Signale ST2).

Der Taktgenerator TG sorgt für den zeitlichen Ablauf der Befehlsschritte. Dabei werden aus einem Takt TC alle anderen Taktschritte abgeleitet.

Da es möglich ist, daß auch der Testprozessor TPZ Fehler aufweist, aufgrund deren er fehlerhaft arbeiten würde, so daß ein von ihm erzeugter Reparaturplan falsch wäre, wird bevor der Speicher getestet wird, der Testprozesso! einem Selbsttest unterzogen. Dieser Selbsttest kann in zwei Abläufe unterteilt werden. In einem ersten Ablauf wird ein kleiner Teil des Testprozessors TPZ von einer zusätzlichen Schaltung getestet. Der restliche Teil des Testprozessors TPZ wird mit der Hilfe eines speziellen Testprogramms getestet.

Im ersten Ablauf des-Testvorganges wird der Befehlszähler BZ ständig hochgezählt. Es werden keine Verzweigungsbefehle ausgeführt. Das Befehlsregister BR wird zu einem Schieberegister zusammengeschaltet (Signale ST7), dann wird das gesamte Programm Befehlswort für Befehlswort in dieses Schieberegister aeladen und eine Signatur berechnet. Am Ende dieses Ablaufs wird die Signatur wird einem Sollwert verglichen. Wenn kein Fehler festgestellt wird, also die Signatur mit dem Sollwert übereinstimmt, dann liegt kein Fehler im Befehlsregister BR, Programmzähler BZ und im RDM BSP vor.

Anschließend wird im zweiten Ablauf der Programmzähler mit dem speziellen Testprogramm geladen. Jetzt sind auch Verzweigungsbefehle ausführbar. Während dieses Ablaufes wird der Datenpfad DF und die Datenpfadsteuerung DST geprüft und zwar, bevor der Test des Speichers durchgeführt wird.

Fehler, die aufgrund dieses speziellen Testprogrammes festgestellt werden oder die mit Hilfe der Signatur festgestellt werden, beenden den Test. Wenn während dieser Abläufe kein Fehler festgestellt wird, dann wird der Testprozessor TPZ als fehlerfrei angesehen.

Mit Hilfe der Fig. 6, die ein Flußdiagramm des Verfahrens zur Feststellung von Fehlern im Speicher SP zeigt, wird die Funktion des Testprozessors erläutert. Das Verfahren beginnt mit dem Schritt Testvorbereitung S1. Während dieses Schrittes S1 kann z.B. der Selbsttest des Testprozessors TPZ durchgeführt werden. Weiterhin können die Register des Registersatzes z.B. in ihren Ausgangszustand gebracht werden.

Im nächsten Schritt S2 wird untersucht, ob alle zu prüfenden Speicherzellen bereits überprüft worden sind. Ist dies nicht der Fall, dann wird ein Testschritt S3 durchgeführt, d.h. der zu prüfenden Speicherzelle wird ein Testmuster zügeführt und das daraufhin von der Speicherzelle abgegebene Ergebnissignal ausgewertet.

Im Schritt S4 wird festgestellt, ob ein Fehler vorliegt. Ist dies nicht der Fall, dann wird mit dem Schritt S2 weitergearbeitet. Liegt jedoch ein Fehler vor, dann wird ein Schritt S5 ausgeführt, indem die Adresse der fehlerhaften Speicherzelle gespeichert wird. Die Abspeicherung dieser Adressen kann im Registersatz des Testprozessors erfolgen. Bei Speichern großer Kapazität würde dies aber dazu führen, daß der Registersatz zu groß wird. In diesem Falle ist es vorteilhafter, die Adressen der fehlerhaften Speicherzellen im Speicher SP abzuspeichern. Dann wird im ersten Schritt S1 ein fehlerfreier Bereich des Speichers SP festgestellt und zwar nach dem Verfahren, das die Schritte S2, S3, S4 enthält. Die Adresse des fehlerfreien Speicherbereichs kann im Registersatz RG abgespeichert werden.

Nachdem die Adresse der fehlerhaften Speicherzelle abgespeichert woren ist, wird im Schritt S6 überprüft, ob überhaupt noch eine Reparatur des Speichers möglich ist. Ist dies der Fall, dann wird mit dem Schritt S2 fortgefahren. Ist dies nicht der Fall, dann ist der Speicherbaustein nicht reparabel und wird als Ausschuß behandelt (Schritt S11).

Wenn im Schritt S2 festgestellt worden ist, daß alle Speicherzellen überprüft worden sind, dann wird im Schritt S7 überprüft, ob ein Fehler festgestellt worden ist. Ist dies nicht der Fall, dann ist der Speicherbaustein einwandfrei und kann ausgeliefert werden (Schritt 12).

Ist jedoch ein Fehler festgestellt worden, dann wird im Schritt S8 vom Testprozessor TPZ ein Reparaturplan erstellt. Die Erstellung des Reparaturplanes zeigt auch, ob der Speicherbaustein repariert werden kann. Die Überprüfung erfolgt im Schritt S9. Ist der Speicherbaustein nicht reparierbar, dann bildet der Ausschuß und kann nicht verwendet werden (Schritt S11).

Ist er dagegen reparabel, dann kann der Speicherbaustein entsprechend dem Reparaturplan repariert werden (Schritt 10), wobei die Reparatur extern erfolgen kann oder intern durch den Testprozessor, wenn die Ersatzzeilen oder Ersatzspalten durch den Testprozessor programmierbar sind.

Der Schritt S3, der Testschritt, kann mit Hilfe von bekannten Verfahren durchgeführt werden. Eine Möglichkeit ist z.B. das Marching-One/Marching-Zero Verfahren. Nach diesen Verfahren werden aufeinanderfolgend eine 0 in jede Speicherzelle eingeschrieben, dann die 0 gelesen und anschließend eine 1 eingeschrieben, dann die 1 gelesen und dann wiederum eine 0 eingeschrieben. Dies erfolgt mit aufsteigenden Adressen und mit fallenden Adressen.

Die Fehlerregistrierung, also der Schritt S5, kann entsprechend dem Verfahren der Fig. 7 durchgeführt werden. Im Schritt F1 wird festgestellt, ob der festgestellte Fehler einer Speicherzelle bereits bekannt ist, also die entsprechende Adresse bereits abgespeichert worden ist. Ist dies der Fall, dann ist das Fehlerfeststellungsverfahren beendet. Ist dies jedoch nicht der Fall, dann wird mit dem Schritt F2 weitergearbeitet. Im Schritt F2 wird festgestellt, ob die Fehleranzahl pro Zeile von Speicherzellen um 1 größer ist als die Anzahl von Ersatzspalten. n ist die Anzahl der Ersatzspalten. Ist dies der Fall, dann ist es nicht mehr erforderlich, diesen Fehler zu registrieren. Denn dann sind in dieser Zeile bereits so viele Fehler festgestellt worden, wie Ersatzspalten vorhanden sind. Liegt dieser Fall vor, dann ist die Fehlerfeststellung beendet. Liegt er nicht vor, dann folgt der Schritt F3.

Im Schritt F3 wird eine entsprechende Feststellung für die Fehler pro Spalte gemacht. Es wird überprüft, ob die Fehler pro Spalte um 1 größer sind als die Anzahl der Ersatzzeilen. m ist die Anzahl der Ersatzzeilen. Ist dies der Fall, wird der Fehler nicht registriert, sonst wird im Schritt F4 die Zahl der Fehler um 1 erhöht.

Im Schritt F5 wird überprüft, ob die Gesamtanzahl der Fehler, die im Schritt F4 festgestellt worden ist, eine festgelegte Grenze überschreitet. Diese Grenze wird errechnet entsprechend der Formel:

$$R = m(n+1) + n(m+1)$$

Überschreitet die Anzahl der festgestellten fehlerhaften Speicherzellen diese Zahl R, dann kann der Speicher SP mit Hilfe der vorhandenen Ersatzzeilen und Ersatzspalten nicht repariert werden. Liegt die Zahl jedoch darunter, dann wird die Adresse der fehlerhaften Speicherzelle gespeichert.

Wenn also z.B. zwei Ersatzspalten und zwei Ersatzzeilen vorgesehen sind, dann beträgt die obere Grenze R = 12. Somit können maximal 12 fehlerhafte Speicherzellen mit Hilfe der Ersatzspalten und Ersatzzeilen repariert werden.

Dies bedeutet jedoch nicht, daß bei Fehleranzahl kleiner R der Speicher immer reparabel ist. Bei sehr ungünstiger Verteilung der Fehler kann trotzdem eine Reparatur nicht möglich sein.

Die Erstellung des Reparaturplanes, also die Ausführung des Schrittes S8 nach Fig. 6, kann nach einem bekannten Verfahren durchgeführt werden. Es kann z.B. der Repair-Most Algorithmus dazu verwendet werden. Das heißt die Zeilen und/oder Spalten, in denen die meisten Fehler auftreten, werden zuerst repariert. Zum Beispiel wird zunächst die Zeile mit den meisten Fehlern repariert, d.h. durch eine Ersatzzeile ersetzt. Anschließend kann die Spalte mit den meisten Fehlern durch eine Ersatzspalte ersetzt werden. Dieser Vorgang wird solange festgesetzt, wie Ersatzzeilen und Ersatzspalten zur Verfügung stehen. Sind auf diese Weise nicht alle fehlerhaften Zellen reparabel, dann ist der Speicherbaustein Ausschuß und kann nicht weiter verwendet werden.

Wie sich aus Fig. 6 ergibt, kann der Speicherbaustein nach der Reparatur noch einmal geprüft werden. Dies ist ohne großen Aufwand möglich, da der Testprozessor TPZ auf dem Speicherbaustein mit integriert ist und den Test ohne weiteres durchführen kann.

**Patentansprüche**

1. Anordnung zur Feststellung und Lokalisierung von fehlerhaften Speicherzellen eines Speichers mit folgenden Merkmalen:

a) Der Speicher ist zusammen mit einem Testprozessor (TPZ) auf einem Speicherbaustein (BS) integriert,

b) der Testprozessor (TPZ) erzeugt im Testbetrieb Testmuster für den zu prüfenden Speicher, wertet die aufgrund der Testmuster von dem Speicher abgegebenen Ergebnissignale aus und speichert bei Feststellung von fehlerhatten Speicherzellen deren Adresse ab, gekennzeichnet durch folgende weitere Merkmale:

c) der Speicher weist zur Reparatur verwendbare Ersatzzeilen und/oder Ersatzspalten auf,

d) der Testprozessor (TPZ) erstellt für fehlerhafte Speicherzellen mit Hilfe der gespeicherten Adressen einen Reparaturplan, nach dem Zeilen/Spalten mit fehlerhaften Speicherzellen durch Ersatzzeilen/Ersatzspalten ersetzbar sind,

e) entsprechend dem Reparaturplan werden im Ansteuerschaltkreis für die Ersatzzeile/Ersatzspalte angeordnete EPROM-Zellen programmiert, so daß die Ersatzzeile/Ersatzspalte die Zeile/Spalte mit fehlerhaften Speicherzellen ersetzt.

2. Anordnung nach Anspruch 1, **gekennzeichnet** durch den Testprozessor (TPZ) aus

a) einem Befehlsspeicher (BSP), in dem die Prüfprogramme gespeichert sind,

b) einem Datenpfad (DF) mit

b1) einer arithmetisch logischen Einheit (ALU), die mit einem zum Speicher (SP) führenden Daten-und Adreßbus (A, B) verbunden ist,

b2) mit einem mit dem Daten- und Adreßbus verbundenen Registersatz (RG),

b3) einem mit dem Daten-und Adreßbus verbundenen Konstanten Speicher (KS), in dem Konstanten gespeichert sind,

c) einer Datenpfadsteuerung (DST), die in Abhängigkeit der vom Befehlsspeicher (BSP) gelieferten Befehle der Testprogramme Steuersignale für die Einheiten des Datenpfades (RG, KS, ALU) erzeugt.

3. Anordnung nach Anspruch 2 **gekennzeichnet** durch eine Datenpfadsteuerung (DST) aus

a) einem Befehlsregister (BR), das aus zwei Teilregistern (IR1,IR2) besteht, in die jeweils ein Befehlswort speicherbar ist,

b) einem Adressendecoder (ADRDEC), der die im Betehlswort enthaltenen Adressen für den Registersatz (RG) bzw. Konstanten Speicher (KS) decodiert,

c) einem Programmzähler (BZ), der als Zähler ausgeführt ist, parallel ladbar ist und der die Adressen der Befehlsworte erzeugt,

d) einem Befehlsdecoder (BEFDEC), der aus den Befehlsworten Steuersignale für die Einheiten des Datenpfades erzeugt.

4. Anordnung nach Anspruch 3 **gekennzeichnet** durch einen Befehlsdecoder (BEFDEC) aus

a) einem ALU-Decoder (ALUDEC), der aus dem Operationscode des Befehlswortes die Steuersignale für den Datenpfad (DF) erzeugt,

b) einem Verzweigungsdecoder (BR-DEC), der entsprechend dem Operationscode eines Befehlswortes und dem Zustand von Abfragebits (FLAG) eine Verzweigungsadresse in dem Befehlszähler (BZ) lädt,

c) einem Taktgenerator (TG).

5. Anordnung nach einem der Ansprüche 2 bis 4, dadurch **gekennzeichnnet**, daß die Adressen der Speicherzellen im Registersatz (RG) gespeichert sind.

6. Anordnung nach einem der Ansprüche 2 bis 5, dadurch **gekennzeichnet**, daß die Testmuster im Konstanten Speicher (KS) gespeichert sind.

7. Anordnung nach einem der vorhergehenden Ansprüche, dadurch **gekennzeichnet**, daß vier Befehlstypen (B1,B2, B3, B4) vorgesehen sind, jeweils einen für Speicheroperationen (BF1), einen für arithmetische Operationen (BF2), einen für Boolsche-Operationen (BF3) und einen für Verzweigungsoperationen (BF4).

8. Anordnung nach einem der vorhergehenden Ansprüche, dadurch **gekennzeichnet**, daß der Testprozessor (TPZ) vor der Überprüfung des Speichers (SP) einen Selbsttest ausführt.

9. Verfahren zur Feststellung und Lokalisierung von fehlerhaften Speicherzellen eines Speichers mit folgenden Schritten:

a) zu Beginn eines Testvorganges wird der auf einem Speicherbaustein (BS) zusammen mit einem Testprozessor (TPZ) angeordnete Speicher vom Testprozessor in den Anfangszustand gebracht,

b) der Testprozessor (TPZ) erzeugt im Testbetrieb Testmuster für den zu prüfenden Speicher, wertet die aufgrund der Testmuster von dem Speicher abgegebenen Ergebnissignale aus und speichert bei Feststellung von fehlerhaften Speicherzellen deren Adresse ab, gekennzeichnet durch folgende weitere Schritte:
c) der Testprozessor (TPZ) erstellt für fehlerhafte Speicherzellen mit Hilfe der gespeicherten Adressen einen Reparaturplan, nach dem Zeilen/Spalten mit fehlerhaften Speicherzellen durch Ersatzzeilen/Ersatzspalten ersetzbar sind,

d) der Testprozessor stellt fest, ob eine Reparatur noch möglich ist, beendet bei negativem Ergebnis die Prüfung und meldet den Baustein als irreparabel, bei positivem Ergebnis setzt er die Schritte b) bis d) solange fort, bis der ganze Speicher überprüft worden ist,

e) der Testprozessor stellt nach Beendigung der Prüfung test, ob fehlerhafte Speicherzellen gefunden worden sind, renn dies nicht der Fall ist, wird der Baustein als fehlerfrei gemeldet, wenn es dagegen der Fall ist, werden entsprechend dem Reparaturplan im Ansteuerschaltkreis für die Ersatzzeile/Ersatzspalte angeordnete EPROM-Zellen programmiert, so daß die Ersatzzeile/Ersatzspalte die Zeile/Spalte mit fehlerhaften Speicherzellen ersetzt.

10. Verfahren nach Anspruch 9, dadurch **gekennzeichnet**, daß der Prozessor zur Registrierung einer fehlerhaften Speicherzelle folgende Schritte ausführt:

a) es wird überprüft, ob die testgestellte Adresse einer fehlerhaften Speicherzelle schon einmal abgespeichert worden ist und für diesen Fall das Verfahren beendet, sonst mit Schritt b) fortgefahren,

b) es wird überprüft, ob die Anzahl der Fehler pro Zeile um 1 größer ist als die Anzahl n der Ersatzspalten und für diesen Fall das Verfahren beendet, sonst mit Schritt c) fortgefahren,

c) es wird überprüft, ob die Anzahl der Fehler pro Spalte um 1 größer ist als die Anzahl m der Ersatzzeilen und für diesen Fall das Verfahren beendet, sonst mit Schritt d) fortgetahren,

d) es wird festgestellt, ob die Anzahl der Fehler die pro Baustein maximal zulässige Anzahl überschreitet und für diesen Fall der Baustein als defekt gemeldet, sonst die Adresse der fehlerhaften Zelle gespeichert.

11. Verfahren nach Anspruch 10, dadurch **gekennzeichnet**, daß die maximale Anzahl von Fehlern dann erreicht ist, wenn die Anzahl der Fehler den Maximalwert von $R = m\,(n+1) + n\,(m+1)$ erreicht.

12. Verfahren nach einem der Ansprüche 9 bis 11, dadurch **gekennzeichnet**, daß zu Beginn eines Testvorganges ein fehlerfreier Bereich des Speichers durch den Testprozessor festgestellt wird und in diesen Bereich die Adressen der fehlerhaften Speicherzellen abgespeichert werden.

13. Verfahren nach einem der Ansprüche 9 bis 12, dadurch **gekennzeichnet**, daß die Erstellung des Reparaturplanes nach der Most-repair Methode erfolgt, d.h. Zeilen oder Spalten, in denen die meisten Fehler auftreten, werden zuerst repariert.

## Claims

1. Arrangement for detecting and localising faulty memory cells of a memory, having the following features:
a) the memory is integrated on a memory module (BS) together with a test processor (TPZ),
b) in the test mode, the test processor (TPZ) generates test patterns for the memory to be tested, evaluates the result signals output by the memory in response to the test pattern and, if faulty memory cells are detected, stores the address thereof, characterised by the following further features:
c) the memory has replacement rows and/or replacement columns which can be used for repairs,
d) the test processor (TPZ) produces a repair plan for faulty memory cells with the aid of the stored addresses, in accordance with which rows/columns with faulty memory cells can be replaced by replacement rows/replacement columns,
e) in accordance with the repair plan, EPROM cells arranged in the drive circuit for the replacement row/replacement column are programmed so that the replacement row/replacement column replaces the row/column with faulty memory cells.

2. Arrangement according to Claim 1, characterised by the test processor (TPZ) comprising
a) an instruction memory (BSP) in which the test programs are stored,
b) a data path (DF) having
b1) an arithmetic logic unit (ALU) which is connected to a data and address bus (A, B) leading to the memory (SP),
b2) having a register set (RG) connected to the data and address bus,
b3) a constants memory (KS) in which constants are stored and which is connected to the data and address bus,
c) a data path controller (DST) which generates control signals for the units of the data path (RG, RK, ALU) depending on the instructions of the test programs supplied by the instruction memory (BSP).

3. Arrangement according to Claim 2, characterised by a data path controller (DST) comprising
a) an instruction register (BR) which is composed of two subregisters (IR1, IR2) in which one instruction word can be stored in each case,

b) an address decoder (ADRDEC) which decodes the addresses contained in the instruction word for the register set (RG) or constants memory (RK) respectively,

c) a program counter (BZ) which is designed as a counter, can be loaded in parallel and which generates the addresses of the instruction words,

d) an instruction decoder (BEFDEC) which generates control signals for the units of the data path from the instruction words.

4. Arrangement according to Claim 3, characterised by an instruction decoder (BEFDEC) comprising

a) an ALU decoder (ALUDEC) which generates the control signals for the data path (DF) from the operation code of the instruction word,

b) a branch decoder (BR-DEC) which loads a branch address in the instruction counter (BZ) in accordance with the operation code of an instruction word and the status of interrogation bits (FLAG),

c) a clock generator (TG).

5. Arrangement according to one of Claims 2 to 4, characterised in that the addresses of the memory cells are stored in the register set (RG).

6. Arrangement according to one of Claims 2 to 5, characterised in that the test patterns are stored in the constants memory (Rs).

7. Arrangement according to one of the preceding claims, characterised in that four instruction types (B1, B2, B3, B4) are provided, in each case one for memory operations (BF1), one for arithmetic operations (BF2), one for Boolean operations (BF3) and one for branch operations (BF4).

8. Arrangement according to one of the preceding claims, characterised in that the test processor (TPZ) executes a self-test before testing the memory (SP).

9. Method for detecting and localizing faulty memory cells of a memory, comprising the following steps:

a) at the beginning of a test procedure, the memory arranged on a memory module (BS) together with a test processor (TPZ) is brought into the initial state by the test processor,

b) in the test mode, the test processor generates test patterns for the memory to be tested, evaluates the result signals output by the memory in response to the test pattern and, if faulty memory cells are detected, stores the address thereof, characterised by the following further steps:

c) the test processor (TPZ) produces a repair plan for faulty memory cells with the aid of the stored addresses, in accordance with which rows/columns with faulty memory cells can be replaced by replacement rows/replacement columns,

d) the test processor determines whether a repair is still possible, in the case of a negative result terminates the test and reports the module to be irreparable, in the case of a positive result it continues with steps b) to d) until the whole memory has been tested,

e) once the testing has been completed, the test processor determines whether faulty memory cells have been found; if this is not the case the module is reported as being fault-free, while if, in contrast, it is the case, EPROM cells arranged in the drive circuit for the replacement row/replacement column are programmed in accordance with the repair plan so that the replacement row/replacement column replaces the row/column with the faulty memory cells.

10. Method according to Claim 9, characterised in that the processor for registering a faulty memory cell executes the following steps:

a) it is tested whether the address of a faulty memory cell determined has already been stored, and if this is the case the procedure is terminated, otherwise it is continued with step b),

b) it is tested whether the number of faults per row is greater by 1 than the number n of replacement columns, and if this is the case the procedure is terminated, otherwise it is continued with step c),

c) it is tested whether the number of faults per column is greater by 1 than the number m of replacement rows, and if this is the case the procedure is terminated, otherwise it is continued with step d),

d) it is determined whether the number of faults exceeds the maximum number permissible per module, and if this is the case the module is reported as defective, otherwise the address of the faulty cell is stored.

11. Method according to Claim 10, characterised in that the maximum number of faults is reached whenever the number of faults reaches the maximum value of $R = m(n+1) + n(m+1)$.

12. Method according to one of Claims 9 to 11, characterised in that at the beginning of a test procedure, a fault-free region of the memory is determined by the test processor and the addresses of the faulty memory cells are stored in this region.

13. Method according to one of Claims 9 to 12, characterised in that the repair plan is produced according to the most-repair method, that is to say rows or columns in which the most faults occur are repaired first.

**Revendications**

1. Dispositif pour déterminer et localiser des cellules défectueuses d'une mémoire, présentant les caractéristiques suivantes :

a) la mémoire est intégrée, conjointement avec un processeur de test (TPZ), sur un module de mémoire (BS),

b) le processeur de test (TPZ) produit, pendant l'exécution du test, des profils de test pour la mémoire à contrôler, évalue les signaux de résultats délivrés par la mémoire sur la base du profil de test et, dans le cas de la détermination de cellules défectueuses de mémoire, mémorise leurs adresses, caractérisé par les autres caractéristiques suivantes :

c) la mémoire possède des lignes de remplacement et/ou des colonnes de remplacement utilisables pour une réparation,

d) le processeur de test (TPZ) établit, pour des cellules défectueuses de mémoire, à l'aide des adresses mémorisées, un plan de réparation, selon lequel des lignes/des colonnes contenant des cellules de mémoire défectueuses doivent être remplacées par des lignes de remplacement/colonnes de remplacement,

e) en fonction du plan de réparation, des cellules EPROM disposées dans le circuit de commande pour les lignes de remplacement/colonnes de remplacement, sont programmées de telle sorte que la ligne de remplacement/la colonne de remplacement remplace la ligne/colonne contenant des cellules de mémoire défectueuses.

2. Dispositif suivant la revendication 1, caractérisé par le fait que le processeur de test (TPZ) est constitué par

a) une mémoire d'instructions (BSP), dans laquelle des programmes de contrôle sont mémorisés,

b) une voie de transmission de données (DF) comportant

b1) une unité logique arithmétique (ALU), qui est raccordée à un bus de transmission de données et d'adresses (A,B) aboutissant à la mémoire (SP),

b2) un ensemble de registres (RG) raccordés au bus de transmission de données et au bus de transmission d'adresses,

b3) une mémoire de constantes (KS), qui est raccordée au bus de transmission de données et d'adresses et dans laquelle sont mémorisées des constantes,

c) une unité (DST) de commande de la voie de transmission de données, qui, en fonction des instructions des programmes de test délivrées par la mémoire d'instructions (BSP) produit des signaux de commande pour les unités de la voie de transmission de données (RG,KS,ALU).

3. Dispositif suivant la revendication 2, caractérisé par une unité (DST) de commande de la voie de transmission de données constituée par

a) un registre d'instructions (BR), qui est constitué par deux registres partiels (IR1,IR2) dans lesquels peut être mémorisé respectivement un mot d'instruction,

b) un décodeur d'adresses (ADRDEC), qui décode les adresses, contenues dans le mot d'instruction, pour l'ensemble de registres (RG) ou la mémoire de constantes (KS),

c) un compteur de programmes (BZ), qui est réalisé sous la forme d'un compteur, peut être chargé en parallèle et produit les adresses des mots d'instructions,

d) un décodeur d'instructions (BEFDEC), qui, à partir des mots d'instructions, produit des signaux de commande pour les unités de la voie de transmission de données.

4. Dispositif suivant la revendication 3, caractérisé par un décodeur d'instructions (BEFDEC) constitué par

a) un décodeur ALU (ALUDEC), qui, à partir du code opération du mot d'instruction, produit les signaux de commande pour la voie de transmission de données (DF),

b) un décodeur de branchement (BR-DEC), qui, en fonction du code opération d'un mot d'instruction et de l'état de bits d'interrogation (FLAG), charge une adresse de branchement dans le compteur d'instructions (BZ),

c) un générateur de cadence (TG).

5. Dispositif suivant l'une des revendications 2 à 4, caractérisé par le fait que les adresses des cellules de mémoire sont mémorisées dans l'ensemble de registres (RG).

6. Dispositif suivant l'une des revendications 2 à 5, caractérisé par le fait que les profils de test sont mémorisés dans la mémoire constante (KS).

7. Dispositif suivant l'une des revendications précédentes, caractérisé par le fait qu'il est prévu quatre types d'instructions (B1,B2,B3,B4), respectivement un type d'instructions pour des opérations (BF1) de la mémoire, un type d'instruction pour des opérations arithmétiques (BF2), un type d'instruction pour des opérations booléennes (BF3) et un type d'instruction pour des opérations de branchement (BF4).

8. Dispositif suivant l'une des revendications précédentes, caractérisé par le fait que le processeur de test (TPZ) exécute un auto-test avant le contrôle de la mémoire (SP).

9. Procédé pour déterminer et localiser des cellules défectueuses d'une mémoire, incluant les étapes suivantes :

a) au début d'un processus de test, la mémoire disposée conjointement avec un processeur de test (TPZ) sur un module de mémoire (BZ) est amenée par le processeur de test à l'état initial,

b) le processeur de test (TPZ) produit, au cours du test, des profils de test pour la mémoire à contrôler, évalue les signaux de résultats délivrés par la mémoire sur la base des profils de test et, dans le cas de la détermination de cellules défectueuses de la mémoire, mémorise leurs adresses, caractérisé par d'autres étapes suivantes :

c) le processeur de test (TPZ) établit, pour des cellules de mémoire défectueuses, à l'aide des adresses mémorisées, un plan de réparation, selon lequel des lignes/colonnes contenant des cellules de mémoire défectueuses peuvent être remplacées par des lignes de remplacement/colonnes de remplacement,

d) le processeur de test détermine si une réparation est encore possible, arrête le contrôle dans le cas d'un résultat négatif et signale le module comme étant irréparable, et, dans le cas d'un résultat positif, poursuit les étapes b) à d) jusqu'à ce que l'ensemble de la mémoire ait été contrôlé,

e) le processeur de test établit, à la fin du contrôle, si des cellules de mémoire défectueuses ont été trouvées, et lorsque ce n'est pas le cas, le module est signalé comme étant exempt de défauts, alors que, lorsque c'est le cas, les cellules EPROM disposées dans le circuit de commande pour les lignes de remplacement/colonnes de remplacement sont programmées en fonction du plan de réparation, de sorte que la ligne de remplacement/la colonne de remplacement remplace la ligne/colonne contenant des cellules de mémoire défectueuses.

10. Procédé suivant la revendication 9, caractérisé par le fait que pour l'enregistrement d'une cellule de mémoire défectueuse, le processeur exécute les étapes suivantes :

a) un contrôle est effectué pour savoir si l'adresse déterminée d'une cellule de mémoire défectueuse a déjà été mémorisée et, dans ce cas, le procédé est interrompu alors que sinon il se poursuit avec l'étape b),

b) un contrôle est effectué pour savoir si le nombre des défauts par ligne est supérieur, de 1, au nombre n des colonnes de remplacement et, dans ce cas, le procédé est interrompu, alors que, sinon, il se poursuit avec l'étape c),

c) une vérification est faite pour savoir si le nombre des défauts par colonne est supérieur, de 1, au nombre m des lignes de remplacement, et dans ce cas, le procédé est arrêté, alors que sinon, il se poursuit avec l'étape d),

d) une détermination est faite pour savoir si le nombre des défauts dépasse le nombre maximum admissible pour chaque module et, dans ce cas, le module est signalé comme étant défectueux, alors que sinon l'adresse de la cellule défectueuse est mémorisée.

11. Procédé suivant la revendication 10, caractérisé par le fait que le nombre maximum de défauts est atteint lorsque le nombre des défauts atteint la valeur maximale $R = m\,(n+1) + n\,(m+1)$.

12. Procédé suivant l'une des revendications 9 à 11, caractérisé par le fait qu'au début d'une opération de test, une zone sans défauts de la mémoire est déterminée au moyen du processeur de test et les adresses des cellules de mémoire défectueuses sont mémorisées dans cette zone.

13. Procédé suivant l'une des revendications 9 à 12, caractérisé par le fait que l'établissement du plan de réparation s'effectue selon la méthode Most-repair, c'est-à-dire que des lignes ou des colonnes, dans lesquelles la plupart des défauts apparaissent, sont réparées en premier.

FIG 1

FIG 2

## FIG 3

BF1

| 0 0 | | RGA | RGB/CONST |

LOAD  0 1
STORE 1 0

BF2

| 0 1 | | RGA | RGB/CONST |

SUB   0 0
CMP   0 1
ADD   1 0
MOVE  1 1

BF3

| 1 0 | . | RGA | RGB/CONST |

NAND 1 0

BF4

| 1 1 | | . ADR |

BNF  0 0
BZF  0 1
BCF  1 0
BRA  1 1

## FIG 4

# FIG 5

# FIG 6

# FIG 7